# EUROPEAN PATENT APPLICATION

(11) **EP 0 840 368 A2**
(43) Date of publication of application: **06.05.1998**
(21) Application number: 97118513.7
(22) Date of filing: 24.10.1997
(51) Int. Cl.: H01L 21/48

(54) **Product and method for placing particles on contact pads of electronic devices**

(30) Priority: 30.10.1996 US 739987
(71) Applicant: E.I. DU PONT DE NEMOURS AND COMPANY, Wilmington Delaware 19898 (US)
(72) Inventor: Saltzberg, Michael Aaron, Narberth, Pennsylvania 19072 (US); Convers, Ronald John, Towanda, Pennsylvania 18848 (US); Cairncross, Allan, Hockessin, Delaware 19707 (US); Beikmohamadi, Allan, Cary, North Carolina 27513 (US)
(74) Representative: Towler, Philip Dean

(57) **Abstract**

An article for use in placing particles on contact pads of electronic devices comprises a surface having an array of tacky and non-tacky areas thereon, wherein the tacky areas are disposed either co-planar with the non-tacky areas or below the plane of the non-tacky areas, the tacky areas having a size and bonding strength suitable for adhesion of one particle thereto and is used to place particles from the tacky areas to contact pads of electronic devices, such as circuit boards used in semiconductor applications.

## Description

### Background Of The Invention

This invention relates to an array of tacky and non-tacky areas for use in placing particles (e.g., solder balls) on contact pads of electronic devices and to a process of using the array to place particles on contact pads of electronic devices.

The placement of particles, such as electrically conductive solder, on contact pads is critical to the adoption of array style semiconductor packages such as ball grid arrays (BGA). Such placement is also critical in the attachment of integrated circuits (IC) to packages or printed circuit boards through "flip chip" processes. Recent attempts have been made to improve, for example, solder ball interconnects, such that more reliable and/or less costly solder connections are made in electronic applications. Despite these efforts, there are still problems associated with the handling and transfer of particles, primarily conductive particles such as solder balls to form solder bumps, on the contact pads of electronic devices. As a result, improved products and methods remain a primary objective in the art.

### Summary Of The Invention

Broadly speaking, the present invention provides a article having an array of tacky and non-tacky areas for use in mounting particles to contact pads of an electronic device and to methods for mounting particles using such an array. Thus, in one embodiment, the invention comprises a article for use in mounting particles to contact pads of a electronic device, the article comprising a surface having thereon an array of tacky and non-tacky areas, wherein each of the tacky areas have a size and bonding strength suitable for adhesion of one solder ball thereto and wherein the tacky areas are not disposed above the plane of the surface.

In another embodiment, the invention comprises the above array in combination with one particle attached to each tacky area.

In yet another embodiment, the method for mounting an array of particles on contact pads of electronic devices, comprises the steps of:
(a) providing a surface having an array of tacky and non-tacky areas thereon, each tacky area having one particle adhered thereto;
(b) placing the particles in intimate contact with contact pads of an electronic device such that the particles are in registry with the contact pads;
(c) disassociating the particles from the tacky areas and adhering the particles to the respective contact pads.

In another embodiment, the method for mounting an array of particles on contact pads of electronic devices comprises the steps of:
(a) providing a surface having an array of tacky and non-tacky areas thereon to contact pads of an electronic device whereby the tacky areas are in registry with the contact pads;
(b) adhering one particle to each tacky area to form an array of particles;
(c) disassociating the particles from the tacky areas and adhering the particles to the respective contact pads.

These and other features of the invention will become apparent upon a further reading of this specification, with reference to the drawings, and the appended claims.

### Brief Description Of The Drawings

Fig. 1 is a section view of a surface having an array of tacky and non-tacky areas thereon in accordance with the invention, wherein the tacky and non-tacky areas are disposed coplanar with one another.

Fig. 2 is a section view of another embodiment of a surface having an array of tacky and non-tacky areas in accordance with the invention, wherein the tacky areas are disposed below the plane of the non-tacky areas.

Fig. 3 is a section view of the array of Fig. 1, shown in combination with a particle adhered to each tacky area.

Fig. 4 is a section view of the array of Fig. 2, shown in combination with a particle adhered to each tacky area.

### Detailed Description Of The Preferred Embodiments

The array and method described herein are particularly suited for use with free-flowing particles. By "free-flowing" is meant that there is no substantial binding force to be overcome when separating a mass of particles into separate discrete particles and that the particles do not stick to one another or clump together under normal conditions of use. A discussion of particle to particle binding forces is presented in US. No. Patent 5,356,751, the entire contents of which is incorporated herein by reference.

For most electronic applications, the preferred particles for use in connection with this invention are electrically conductive materials, such as Cu, In, Pb, Sn, Au, and alloys thereof. Most preferred are solder balls. It will be apparent to those skilled in the art, however, that the type of particle used in connection with the present invention is dictated by the particular application and is not a inherent limitation of the invention. For example, a particular application may require that an electrically insulating material be applied to a solder bump on a contact pad; e.g. to space one contact pad from another in a stack of circuit boards. The present invention may be used to advantage in such circumstances. Generally speaking, spherical particles will be preferred in the practice of this invention because of their ease in handling and particle symmetry. It is to be understood, however, that the size and shape of the particles is not critical to the invention.

As used herein, the term "tacky areas" means areas having adhesive properties to enable a bond to form immediately upon contact with free-flowing particles under low pressure (e.g., the weight of the particles). Each tacky area should have a size and bonding strength suitable for adhesion of one free-flowing particle. In accordance with this invention, the tacky areas have a size and bonding strength suitable for adhesion of one particle per tacky area. Typically, the tacky areas are small shapes (i.e., dots) from about 0.25 µm to 1000 µm and for many embodiments they are from about 10 µm to 500 µm. The tacky area shapes may be circular, square, rectangular, oval, or another shape suitable for retention of the particle. Generally, circular shaped tacky areas are preferred.

The spacing of the tacky areas is such that the position of one particle on one tacky area relative to the position of other particles on adjacent tacky areas matches the distance between and relative position of the contact pads of the electronic device to which the particles will become attached. The location of the tacky areas at least must allow the particles to touch some part of the contact pad to which it will become attached. In the embodiment where the particle melts (e.g., solder particles in contact with solder flux and a metallized contact pad), direct contact is required between the molten particle and the pad so that the molten particle can wet the pad and flow across the metal surface to cover the metallized pad. The initial contact of the particle with the metallized contact pad may be off-center because the wetting action of the molten particle will center the particle over the pad during attachment. For these noncritical embodiments, the original pattern of tacky areas is such that the location of each tacky area must align and overlap somewhere within the area of the corresponding contact pad area to which it will attach and the size of the tacky area must be smaller than the particle so that only one particle is attached to each tacky area. Typically, for a tacky area having a particular size and bonding strength, there is a upper limit to the size and weight of particle, above which there is no substantial particle adherence, and there is a lower limit to the size particle which will adhere singly to each tacky area. For tacky areas with a tackiness of 2 to 6 grams/mm² and particles of 0.127 to 0.762 mm (0.005 to 0.030 inch) diameters, the tacky area may be as small as 15% of the particle diameter to as large as 100% of the particle diameter and still get single particle attachment per tacky area. A tacky area of 30% of the particle diameter is preferred.

In the embodiment where the contact pads are close together relative to the size of the particle, care must be taken so that the particles on adjacent tacky areas do not touch before and during attachment to the contact pads so as to avoid bridging adjacent contact pads. As the space between contact pads become smaller relative to the width of the pad and hence, to the width of the particle to be attached to the contact pad, it becomes critical to align the tacky areas ad particles closer to the center of the matching contact pads to which the particle will become attached. This is accomplished by centering the tacky area positions in the imaging step to match the center of the contact pads and using smaller tacky areas to attach one particle in the center of the aligned tacky area. For good alignment, the tacky dot is preferably 30% of the particle diameter and for extremely close tolerances, the tacky dot is preferably smaller than 30% of the particle diameter, as small as 15% of the particle diameter.

Single particle attachment to each tacky area is assured when the size of the particle is large enough to cover the tacky area upon attachment, thus preventing further particles from ever touching the tacky area of an occupied tacky area. For the preferred embodiments of spherical particles and circular tacky dot areas, this is achieved once the diameter of the tacky dot area is less than the diameter of the smallest particle. A narrow size range for the particles is also desired to control the volume after the particle is attached to the contact pad. A uniform particle diameter is also desired for good contact between particles attached to tacky areas on a transfer substrate and the contact pads of the electronic device to which the particle is to be transferred. A size range of +/- 10% for the particle diameter is preferred.

The array of tacky and non-tacky areas preferably has clearly defined tacky areas and has no foreign material adhered thereto. Most preferably, the non-tacky areas are flat and smooth and are disposed co-planar with the tacky areas. Although not preferred, the tacky areas may be disposed below the plane of the non-tacky areas.

In a particularly preferred embodiment, the array of tacky and non-tacky areas comprises a photosensitive element that has been imagewise exposed to create the array. A variety of positive and negative photosensitive compositions are known to produce tacky images and may be used in the practice of this invention. Phototackifiable compositions become tacky where struck by light and are exemplified by compositions described in US. Patent No. 5,093,221, US. Patent No. 5,071,731, US. Patent No. 4,294,909, US. Patent No. 4,356,252 and German Patent No. 3,514,768. Photohardenable compositions are those which become hardened in light struck areas. A number of photohardenable compositions include Cromalin® Positive Proofing Film SN 556548, Cromalin® 4BX, Surphex™ embossable photopolymer film, Cromatone® Negative Overlay Film SN 031372, and Cromalin® Negative Film C/N all available from E. I. du Pont de Nemours and Company, Wilmington, DE. Cromalin® Positive Film SN 556548, Cromalin® 4BX and Surphex™ are preferred. These and other photosensitive products are disclosed in US. Patent No. 3,649,268, US. Patent No. 4,174,216, US. Patent No. 4,282,308, US. Patent No. 4,948,704 and US. Patent No. 5,001,037, the disclosures of which are incorporated herein by reference.

Photohardenable compositions are generally a combination of polymeric binder and photopolymerizable monomers. Suitable binders include co(methyl methacrylate/methacrylic acid) and monoethyl ester of poly(methyl vinyl ether/maleic anhydride), each of which may be copolymerized in various proportions. Suitable photopolymerizable monomers include ethylenically unsaturated monomers which have been found useful are those disclosed in US. Patent No. 2,760,863; US. Patent No. 3,380,831 and US. Patent No. 3,573,918. There may be mentioned as examples dipentaerythritol acrylate (50% tetra and 50% penta), penta-erythritol triacrylate and tetraacrylate, polypropylene glycol (50) ether of pentaerythritol tetraacrylate, polyethylene glycol (200) dimethacrylate, dipentaerythritol triacrylate β-hydroxyethyl ether, polypropylene glycol (550) ether of pentaerythritol tetramethacrylate, pentaerythritol tetramethacrylate, polypropylene glycol (425) dimethacrylate, trimethylolpropane trimethacrylate, and polypropylene glycol (340) ether of trimethylol propane triacrylate. Also useful are epoxy monomers containing ethylene unsaturation, e.g., monomers of the type disclosed in US. Patent No. 3,661,576 and British Patent No. 1,006,587. The binder may be varied widely in its ratio with the monomer but in general it should be in the rage of 3:1 to 1:3. The monomer should be compatible with, and may be a solvent for, and/or have a plasticizing action on the binder. The choice and proportions of monomer and binder are made in accordance with the requirements of selective photoadherence.

When using photosensitive compositions to create the array of tacky and non-tacky areas, the photosensitve composition is first applied to a suitable substrate and is then imagewise exposed to create the desired array of tacky and non-tacky areas. As discussed more fully below, the choice of substrate will largely depend upon the method selected to mount the array of particles to the contact pads. Generally speaking, however, the substrate should be stable under the conditions of intended use, smooth, and show good adherence to the photosensitive composition. As will be recognized by those skilled in the art, one or more intermediate layers may be applied to the substrate to improve adhesion of the photosensitive layer.

There should be facile control of the tacky areas with respect to size and placement. For the aforementioned photosensitive products, the array pattern is first composed by manual or computer assisted design, and is usually transferred to a photographic film that is used as a phototool in contact with the photosensitive product and with strong ultraviolet light to pattern the tacky array in the photosensitive product. For the Cromalin® products, the photosensitive material would first be laminated to the clear substrate and then exposed through the phototool to create the pattern. The pattern could be made to coincide with the interconnect positions of a circuit board. For Cromatone®, a clear plastic film substrate is provided with the product so that it may be exposed directly through the phototool. Other patterning methods include projection exposure and direct writing as in digital imaging using a laser output device.

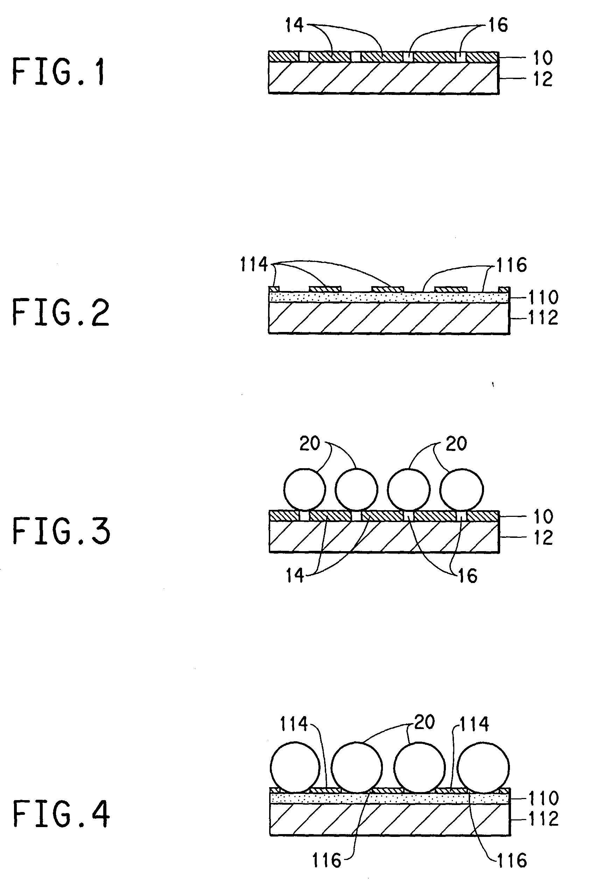

With reference now being made to Fig. 1, an article having an array of tacky and non-tacky areas in accordance with the invention is illustrated therein. In the embodiment shown, the article comprises a photosensitive layer 10 applied to a substrate 12. The photosensitive layer 10 has been imagewise exposed to produce alternating areas 14 which are non-tacky and areas 16 which are tacky. If the photosensitive layer 10 is a phototackifiable composition, the areas 16 would correspond to the exposed areas whereas if the photosensitive layer 10 is a photohardenable composition, areas 16 would correspond to the unexposed areas.

Alternatively, the article may be formed by attaching a thin sheet material having an array of holes to an adhesive coated substrate. Examples of such sheet material include screen mesh or stencils wherein holes have been formed by, for example, laser ablation, punching, drilling, etching, or electroforming. The article may also be formed by providing photoresist hole patterns on a adhesive coated substrate. An example of such an alternate array is illustrated in Fig. 2, wherein an adhesive layer 110 is applied to a substrate 112. A thin sheet material 114 having holes 116 therein is then applied over the adhesive layer 110. The adhesive layer 110 is exposed in the areas of the holes 116 in the sheet material 114. It will be apparent to those skilled in the art that a similar type of structure, that is, a non-tacky surface having recessed tacky areas, will also result from the use of certain photosensitive materials (e.g. negative Cromalin® or Cromotone®) which produce a "peel-apart" image. Generally, the further the tacky area is recessed in relation to the non-tacky area, the more likely size exclusion will occur, where no particles larger than the width at the tacky area recess, will attach. This effect becomes particularly pronounced as the tacky area recess approaches the size of the tacky area, that is, the depth of the tacky area is approximately equal to its width.

It is noted that in the embodiment shown in Fig. 1, the tacky areas 16 are disposed co-planar with the non-tacky areas 14 whereas in the embodiment of Fig. 2, the tacky areas, corresponding to holes 116, are disposed below the plane of the sheet material 114, which defines the non-tacky areas. While it is possible to apply an array of tacky areas above the plane of the non-tacky areas, such as is disclosed in Japanese Unexamined Patent Application (Kokai) No. 6-333,930, that is not within the scope of the present invention. More particularly, applying an array of tacky areas above the plane of a non-tacky surface makes it difficult to obtain precise registration of solder balls such as is needed in electronic applications because it is difficult to avoid adhering the solder ball to the sides of the raised tacky area and thus difficult to center the solder ball on the tacky area. In addition, arrays having raised tacky areas are prone to deform during storage and handling, again making them unsuitable for applications requiring precise placement or registration of the tacky areas and the solder balls.

This step may be accomplished in a number of ways. Generally the article with the pattern of tacky areas is placed in a container with an excess of particles and the container gently moved so as to allow the particles to move across the array until all tacky areas become occupied. Excess particles are removed from the fully occupied pattern of tacky areas by gravity, gentle tapping, gentle blowing, vacuum and other methods. The force used in the clean up of excess particles depends on the adhesive strength of the bond between the tacky areas and the particles. This step, the application of free flowing particles to patterns of tacky areas, is accomplished best when electrostatic charging is avoided by using electrically conducting, grounded containers, humidified atmosphere and with the use of ion generators as in the use of ionized air. This step is further aided by a clean atmosphere to prevent the attachment of foreign matter to the tacky areas. Figures 3 and 4 illustrate the embodiments of the array shown in Figures 1 and 2, respectively, with spherical particles 20 attached to the tacky areas 16, 116 of the array.

The process of attaching particles to patterns of tacky areas is aided by the tacky areas having sufficient tackiness to grab and hold the particles immediately upon contact It is further desired for the attachment of the particle to the tacky area to be strong enough to withstand the various forces (e.g., moving, bumping contact, vacuum or blowing forces, etc.) that occur while populating the array with particles and during the removal of excess particles from the fully populated array. In addition, it is advantageous to have sufficient adhesive strength between the particles and the tacky areas to hold the particles in place during handling and possible shipment. It has been found by the present inventors that tacky areas with a tackiness of 0.5 grams/mm² can be populated by particles, that greater than 2 g/mm² is preferred and greater than 5 g/mm² is much preferred especially when patterns of tacky areas populated with particles are to be shipped without loss of the particles.

When the pattern of tacky areas is not used immediately, or is stored or shipped, it is useful to keep the tacky areas clean by protecting them with a cover sheet such as a polyester film, polypropylene film, or silicone release polyester film. Generally a thin 0.0127 mm (0.0005 inch) Mylar® polyester film (E. I. du Pont de Nemours and Company, Inc., Wilmington, DE) is sufficient.

The invention also relates to transferring the array of mounted particles described above to contact pads of an electronic device. The contact pads are usually made of a conductive metal such as copper, aluminum, gold, or a lead/tin solder. In the preferred embodiment, an array having a single particle adhered to the tacky areas thereof is placed in contact with the contact pads of an electronic device such that the particles are placed in registered contact with each of the contact pads and the particles are then released from the tacky areas of the array and are adhered to the contact pads. This method will be referred to as the "transfer method." In an alternate embodiment, the array of tacky and non-tacky areas is formed directly on the contact pads (such as by coating, laminating etc.) prior to the particles being adhered thereto. This method will be referred to as the "direct method."

In either the transfer method or the direct method, it is necessary to disassociate the particles from the tacky areas of the array. There are may alternate methods to accomplish this step, some of which are more applicable to either the direct method or the transfer method than to the other. For example, disassociation of the particles can be accomplished by mechanical forces, that is, an adhesive compound (e.g., an adhesive flux) can be applied to the contact pad. Upon contact of the solder ball to the adhesive compound, a bond forms which is stronger than the bond between the solder ball and the tacky area of the array. Thus, upon removal of the array from the contact pads, the particles are released from the tacky areas and remain adhered to the contact pads. Mechanical disassociation of the particles is particularly applicable to the transfer method.

Thermal disassociation is yet another method of disassociating the particles from the array. By thermal disassociation is meant the application of heat sufficient to cause the particles to melt, wet the surface of the contact pads and flow to cover the pads. Preferably, as the particles melt, the substrate is brought closer to the contact pads to make sure that all particles contact their respective contact pads. Spacers may be used to keep the surface uniformly off contact from the contact pads themselves so as not to squeeze solder beyond the contact pads.

The heat necessary to melt the particles may be provided by use of an oven, laser, microwave, infrared radiation or other convenient source. Temperatures in the range of 150°C to 400°C are normally sufficient to cause the reflow of the particles, particularly solder balls. It will be apparent to the skilled artisan that, in the event the substrate will be heated together with the particles, the substrate should be capable of withstanding such temperatures; that is, it should be thermally stable. Substrates such as Kapton® (a polyimide film available from E. I. du Pont de Nemours and Company, Wilmington, DE), quartz, glass and the like may be used to advantage. Likewise, the material used to form the tacky and non-tacky array should not be such that it contaminates the electronic device during thermal processing. Preferably, the material will be thermally stable. Alternatively, it could completely volatilize during the heat step temperatures. Negative Cromalin® in particular had a tendency to melt during a oven heating disassociation step and thus is largely unsuitable for use with oven heating. In the event that the heat source used will not heat the substrate (e.g., a laser), thermal stability is not of great concern.

Another method that may be used to disassociate the particles is photodisassociation. In this method, the tacky areas are exposed to actinic radiation whereby they lose their adhesive properties to disassociate the particle.

To improve the wetting and adhesion of the particle, particularly solder balls, to the contact pads, a suitable flux may be used. A solder flux combination (e.g., rosin types, no-clean types, organic acid or synthetic activated) can be coated on the pads areas and/or on the solder balls to help effect disassociation of the solder ball from the tacky area and adhesion thereof to the contact pad.

In the direct method, it is critical that the molten particle displace the tacky area on the contact pad and completely wet the contact pad with the molten particle (e.g., solder). This could be accomplished by decomposing the tacky areas to volatile compounds when the melting temperature of the particles is reached or by using thermally stable tacky area materials that would be displaced by the molten particle.

Once the particles have been released from the tacky areas and melted, they are allowed to cool and resolidify on the contact pads, e.g., to form a solder bump.

### Examples

### Example 1.

Various versions of positive Cromalin® (identified below) ranging from 4 to 25 µ thick were laminated to 75 µ thick 300H Kapton® film using a Cromalin® laminator at 102°C to 110°C (215°F to 230°F) under yellow safelight. A 12µ thick Mylar® polyester cover sheet was also used.

The tackiness of these Cromalin® samples was then measured by placing a large 1.3 cm (0.5 inch) diameter dot in contact with the Mylar® cover sheet and exposing the sample to 4 to 10 mj/cm² of UV light (λ = 365 nm). The cover sheet was then removed and a post was placed vertically in contact with the tacky area. The amount of force necessary to remove the post from the tacky dot was measured. Results are shown in Table 1.

**Table 1**

| Example | Type of positive Cromalin® | Thickness of Cromalin® layer (microns) | Tackiness (g/mm²) |
|---|---|---|---|
| 1A | 4BX | 4 | 5.4 |
| 1B | C4/CP | 8 | 1.9 |
| 1C | I-CFD | 25 | 2.7 |

### Example 2.

A 4 micron thick film of Cromalin® 4BX having a 12 micron thick Mylar® cover sheet was laminated onto 15 cm x 15 cm x 0.32 cm (6 x 6 x 0.125 inch) glass, 15 cm x 15 cm x 0.16 cm (6 x 6 x 0.0625 inch) glass and standard microscop slides using a Cromalin® laminator at 110°C (230°F).

### Example 3.

The following example illustrates the coating of the tacky photosensitive composition directly on Kapton® polyimide film. The ingredients set forth below are dissolved in 1:1(wt:wt) toluene/methanol at 23.1% solids in the order listed below. The zinc acetylacetonate and N, N-diethylhydroxylamine were dissolved together in methanol in a separate part and added last to the solution of the rest of the ingredients. The combined solution of all the ingredients was stirred at least 24 hours, coated on 0.025 mm (0.002 inch) 200HN Kapton® polyimide film, air dried at 37.8 to 60°C (100 to 140°F) to give coating weights of 56 and 81 mg/dm². At the exit of the drier, a 0.013 mm (0.0005 inch) thick 48S Mylar® polyethylene terephthalate cover sheet was calendered onto the coating at room temperature.

| Ingredient | Amount (grams) |
|---|---|
| Diacrylate ester of bisphenol A epoxy resin derived from bisphenol A and epichlorohydrin. [Viscosity @25°C = 10⁶ cps] | 3494 |
| Ethyl acrylate/acrylic acid copolymer, Acid No. = 63, MW 7,000 | 1053 |
| Glycerol triacetate | 1267 |
| Trimethylolpropanetrimethacrylate | 2564 |
| Toluene | 22033 |
| Methanol | 18145 |
| Ethyl acrylate (25.8)/methylmethacrylate (61.2)/acrylic acid (12.5), MW = 101-190,000, Acid No. = 100,Tg = 80°C | 4720 |
| Ethyl acrylate (56)/methylmethacrylate (37)/acrylic acid (7), MW = 156-199,000; Acid No. = 57; Tg = 33°C | 3391 |
| Trimethylolpropane | 954 |
| Optical brightener⁽¹⁾ | 386 |
| 2-Mercaptobenzoxazole | 156 |
| 2,2'-Bis-(o-chlorophenyl)-4,4',5,5' tetraphenylbiimidazole | 321 |
| Thermal inhibitor⁽²⁾ | 9.3 |
| Methoxyhydroquinone | 5.0 |
| Zinc acetylacetonate | 432 |
| Diethylhydroxylamine | 20.2 |
| Methanol | 3888 |

| | |
|---|---|
| (1) 7-(4'Chloro-6'-diethylamino 1',3',5'-triazine 4'-yl)amino 3-phenyl coumarin | |
| (2) 1,4,4-Trimethyl-2,3-diazobicyclo-(3.2.2)-non-2-ene-2,3-dioxide | |

### Example 4.

Example 3 was repeated except that the photosensitive composition was coated directly onto a 12 micron thick Mylar® film and a 50 micron 200 HD Kapton® cover sheet was calendered onto the coating as it exited the dryer.

### Example 5.

Negative Cromalin® C/N was laminated to glass slides and was then imaged to give an array of dots having a 100 micron diameter at 1000 micron pitch (the space between dots, measured center-to-center). Type 3 solder balls (25-45 microns diameter) having a composition of 62%Sn/36%Pb/2%Ag (mp 179°C) were freely flowed over the dot pattern attaching 7 to 10 solder balls on each tacky dot. No solder balls attached to the non-tacky areas. The array of solder balls was then placed in contact with copper clad Kapton® and heated in a 210°C oven for 7.5 minutes. The solder balls remained on the glass slide, fused together on the tacky dots. Part of the negative Cromalin® appears to melt and transfers to the copper as a clear deposit.

### Example 6.

Positive Cromalin® 4BX was laminated to 300H Kapton® and was imaged with UV light to give patterns of 375 microns (15 mil) diameter tacky dots at 1250 and 1750 microns (50 and 70 mil) pitch. Solder balls having a diameter of 750 ⁺/₋ 12 microns (30 ⁺/₋ 0.5 mils) an a composition of 63%Sn/37%Pb were flowed over the tacky dot pattern. Excess balls were removed by tipping the Kapton® and gently tapping or blowing, leaving patterns with perfect populations of 100% single solder balls on each tacky dot.

Mirror image patterns of 750 micron (30 mil) openings with 1250 and 1750 microns (50 and 70 mil) pitches were made in 50 microns (2 mil) thick photoresist layers on copper-clad FR4 laminate boards. Solder flux 9553 was lightly spread over the 30 mil openings wetting the copper. The array of solder balls was brought into registered contact with the copper-clad FR4 board and visually aligned so that each solder ball was over its corresponding opening in the resist pattern and the solder balls rested on the flux.

The entire assembly was then placed in a 216°C oven for 5 minutes, cooled and the array lifted away. All solder balls bonded to the copper at the bottom of the openings in the resist on the Cu/FR4 board and formed patterns of solder bumps of 750 micron (30 mil) diameter and 1250 to 1750 micron (50 and 70 mil) pitch. The array retained a clear layer of baked Cromalin® 4BX with small dimples where there used to be tacky dots. No solder remained on the array.

### Example 7.

Four tacky dot patterns were made in Cromalin® 4BX on 300H Kapton® with the goal of mounting 250 micron (10 mil) diameter solder balls with 500 micron (20 mil) pitch. The size (diameter) of the tacky dots were 65, 100, 137.5, and 167.5 micron (2.6, 4.0, 5.5, and 6.7 mil) which corresponds to 26% to 67% of the diameter of the solder ball.

The array of tacky dots was populated by flowing solder balls (65%Sn/37%Pb) over the array and tapping off the excess. In each case, the same pattern was obtained; one solder ball per tacky dot, 250 micron (10 mil) solder balls at 500 micron (20 mil) pitch, 100% perfect population. The alignment of the solder balls using 65 micron (2.6 mil) tacky dots was near perfect straight lines and near uniform 250 micron (10 mil) gaps between balls. In the sample having the 167.5 micron (6.7 mil) diameter dots, the alignment was quite sloppy giving a ragged line of balls, albeit with no solder balls touching one another.

### Example 8.

A test image was created with arrays of dots for mounting 500 micron (20 mil) balls at 750 micron (30 mil) pitch where the tacky dot diameters were 150, 137.5, 125, 112.5, 100, 87.5 and 75 microns (6.0, 5.5, 5.0, 4.5, 4.0, 3.5, and 3.0 mils), which corresponds to 15% to 30% of the diameter of the solder ball. The composition described in Example 2 was coated onto 50 micron (2 mil) thick Kapton® and a tacky dot image was made and populated with solder balls. Excess solder balls were removed by tapping.

All tacky dots, including the 75 micron dots, accepted 1 solder ball per dot, 100% populated. The alignment of the solder balls became increasingly better as the diameter of the tacky dots decreased. It did, however, take longer to populate the dots as they became smaller. The 100% populated sample was shipped across the United States by Express Mail with no loss of solder balls.

### Example 9.

A test image was created with arrays of dots for mounting 500 micron (20 mil) solder balls at 750 micron (30 mil) pitch where the tacky dot size was 150 microns (6 mils), corresponding to 30% of the diameter of the solder balls. The composition of Example 2 was coated on 50 micron (2 mil) thick Kapton®, a tacky dot image was made and then populated by pouring an excess of 63%Sn/37%Pb solder balls on the image, jiggling to assure complete population and tapping off the excess. The sample was perfectly populated with 4,760 20 mil solder balls with good alignment and spacing between each ball.

Next, DuPont QS190 Copper Conductor Thick Film Composition was screen printed on an alumina substrate to create a pattern of 555 micron (22.2 mil) contact pads that matched the pattern of the tacky dot array. The copper/alumina substrate was then fired in a 30 minute fast fire oven with a peak temperature of 600°C for 5 minutes under nitrogen atmosphere.

A thin layer of solder paste flux/ no-clean liquid flux was then applied to the copper pads. The solder balls in the array were then visually aligned and brought into registered contact with the fluxed coated copper pads. The assembly was then conveyed into a forced convection reflow oven under nitrogen atmosphere and heated from 25°C to 225°C at a rate of 1.0 to 1.1°C/sec, maintained at 225°C for 20-25 seconds, and then cooled. After a total reflow time of 265 seconds, the assembly was removed from the oven and the array was separated from the copper/alumina sheet. All 4,760 solder balls had transferred to the copper pads to form solder bumps. No solder remained on the Kapton®/Cromalin® array.

### Example 10.

Positive Cromalin® 4BX was laminated to clean copper clad FR4 board and the cover sheet removed. About 80 solder balls of 500 micron (20 mil) diameter were randomly sprinkled onto the tacky Cromalin® causing random attachment. The board was then passed through a forced convection reflow oven under nitrogen atmosphere. About 20% of the solder balls formed a physically good bond with the copper, about 75% had good conductivity, and about 5% had no conductivity. This example demonstrates that Cromalin® 4BX acts as an adhesive attaching solder balls to copper, has some flux characteristics and, upon reflow, can give a low yield of direct attachment of solder balls to copper to form solder bumps.

### Example 11.

Example 10 was repeated, except that the solder balls were coated with no-clean solder flux and air dried before being randomly sprinkled onto the Cromalin® 4BX. After reflow, the solder balls had formed solder bumps with excellent contact, conductivity and bonding with the copper. Thus, during reflow, the flux coating on the solder balls became active and penetrated through the Cromalin® to promote bonding to copper by removing the metal oxides and other contaminants.

### Example 12.

Positive Cromalin® on a glass substrate was exposed by 2 mj/cm² or UV light through a phototool with 38.1 micron (0.0015 inch) opaque dots corresponding to the locations of contact pads on a wafer. The imaged array was then placed in grounded conducting trays in filtered clean air at 34% relative humidity and discharged using ionized air. The Mylar® cover sheet was then removed and the electrostatic discharge continued with ionized air.

A large quantity of 127 micron (0.005 inch) diameter solder balls (63%Sn/37%Pb) were poured from a grounded conducting tray over the array, completely covering the tacky areas with a thin layer of solder balls. The grounded pan containing the array was then agitated causing the excess solder balls to bounce vertically on the array. The array was then titled to remove the excess solder balls, leaving an array populated with 16,520 solder balls in the desired locations at pitches varying from 203 to 457 microns (0.008 to 0.018 inch) which perfectly matched the locations of the I/O pads on the wafer.

### Example 13.

The following example illustrates the coating of a tacky photosensitive composition on Mylar® polyester film; imaging to make pattern of tacky dots; populating the tacky dots with solder balls; placing the populated image in contact with a fluxed substrate and irradiating with ultraviolet light through the Mylar® film from the side not containing the solder bails so as to increase the release of solder balls to the fluxed substrate by photorelease. The ingredients set forth below are dissolved in 1:1 (wt:wt) toluene/methanol, coated on 0.050 mm (0.002 inch) thick 200D Mylar® polyester film using a doctor knife, air dried and protected with 0.013 mm (0.0005 inch) thick 48S Mylar® cover sheet.

| Ingredient | Amount (% dry wt.) |
|---|---|
| Diacrylate ester of bisphenol A epoxy resin derived from bisphenol A and epichlorohydrin. [Viscosity @25°C = 10⁶ cps] | 18.6 |
| Trimethylolpropanetrimethacrylate | 13.65 |
| Ethyl acrylate (25.8)/methylmethacrylate (61.2)/acrylic acid (12.5), MW = 101-190,000, Acid No. = 100, Tg = 80°C | 27.24 |
| Ethyl acrylate (56)/methylmethacrylate (37)/acrylic acid (7), Acid No. = 57; MW= 156-199,000; Tg = 33°C | 18.06 |
| Optical brightener⁽¹⁾ | 2.06 |
| 2-Mercaptobenzoxazole | 0.82 |
| Tetraethyleneglycoldimethacrylate | 14.58 |
| 2,2'-Bis-(o-chlorophenyl)-4,4',5,5' tetraphenylbiimidazole | 2.61 |
| Thermal inhibitor⁽²⁾ | 0.05 |
| Methoxyhydroquinone | 0.03 |
| Zinc acetylacetonate | 2.30 |

| | |
|---|---|
| (1) 7-(4'Chloro-6'-diethylamino 1',3',5'-triazine 4'-yl)amino 3-phenyl coumarin | |
| (2) 1,4,4-Trimethyl-2,3-diazobicyclo-(3.2.2)-non-2-ene-2,3-dioxide | |

The coated film is contact exposed through the 48S Mylar® to a dot pattern so as to form an array of 0.152 mm (0.006 inch) diameter tacky dots with 0.762 mm (0.030 inch) spacings center-to-center. The 48S Mylar® cover sheet is removed and an excess of 0.51 mm (0.020 inch) diameter solder balls flowed across the tacky dot pattern to populate each dot with one solder ball. The pattern holds a total of 600 solder balls. This was inverted onto a substrate thinly coated with FORMON® 9553 (a rosin based solder flux available from E. I. du Pont de Nemours and Company, Wilmington, DE) so that the solder balls touch the flux. The assembly was irradiated with 2,000 millijoules of ultraviolet light for sample #1 and no ultraviolet light for sample #2. The 200D Mylar® is lifted off the substrate and the number of released balls that transferred to the substrate are counted. Significantly more solder balls transferred with UV exposure than without.

| Sample # | UV Exposure | number of balls released | % Release |
|---|---|---|---|
| 1 | yes | 98 | 16.3 |
| 2 | no | 23 | 3.8 |

A gentle tap after UV exposure increased the percent release to about 70%.

### Example 14.

The following example illustrates the formation of array patterns of tacky dots above a layer of copper by photoimaging, the attachment of solder balls coated with solder flux to the tacky dots, thermal reflow of the solder and bonding of the solder to the copper underneath the tacky dot as a pattern of solder bumps.

Positive Cromalin® 4BX is laminated at 102°C (215°F) to pre-cleaned copper clad FR4 boards and contact exposed with ultraviolet light at 7 millijoules per centimeter square through a pattern of 0.381 mm (0-015 inch) dots at 1.78 mm (0.070 inch) pitch. 0.51 mm (0.020 inch) solder balls (63%Sn/37%Pb) are coated with a IF2005M no-clean solder flux solution and dried to form free-flowing flux-coated solder balls. In yellow safelight, the Mylar® cover sheet is removed from the imaged FR4 boards and the fluxed solder balls flowed onto the tacky dot pattern attaching one fluxed solder ball on each tacky dot to form an array of solder balls. This is passed through a Vitronic Forced Convection reflow oven under nitrogen atmosphere with a temperature ramp speed of 1.0 to 1.1 °C/sec from 25°C to 225°C to 180°C with a dwell time of 20 to 25 sec at 225°C. The total reflow time is 265 seconds. This forms a pattern of nice rounded solder bumps attached to the copper surface of the board. The flux coated solder penetrates through the tacky dots onto the copper surface and forms mechanical bonds. All reflowed solder balls tested had electrical continuity between the solder balls and the copper surface indicating there is metal-to-metal contact between the solder balls and copper.

### Example 15.

Example 14 was repeated except that QT779OA water soluble flux was used to coat the solder balls and the flux was cleaned off immediately after reflow.

### Example 16.

A plurality of flux coated solder balls as in Example 14 were used to populate an array of tacky areas formed in Positive Cromalin® 4BX on Kapton®. The populated array was then inverted and placed into registered contact with copper pads on an Al₂O₃ substrate. No flux was applied to the substrate or the copper pads. The assembly was then subjected to reflow, handled and examined as in Example 9. The resulting solder bumps showed strong mechanical contact and very good electrical conductivity with the copper pads of the substrate.

### Example 17.

The following photosensitive compositions A - J were prepared and coated at a wet thickness of 0.25 mm on Kapton® HN polyimide film and on electric discharge (ED-) treated 200D Mylar® 0.051 mm thick polyester film and dried. When dry, the coatings were laminated with untreated 48S Mylar® 0.13 mm thick polyester film.

For each of the tacky photosensitive compositions A-J, the imaging window was determined to ascertain the best imaging light intensity in millijoules (mj) using a Riston® PC 130 exposure unit. The imaging window ranged from 1 - 50 mj.

Next, the tackiness of the compositions was measured by using Tack Meter "Chatillon Model LTCM-4, and Digital Force/Torque Gauge Model DGGS". The test utilized is ANSI/IPC-SP-819 4.6.4.2-4. The test probe utilized has 20.4 mm² of area. The test procedure involves applying 300+/- 30 grams of force to the specimen, at a rate of 2.5 +/- 0.5 mm. Within 5 seconds following application of the force, the probe is withdrawn from the specimen at a rate of 2.5 +/- 0.5 mm and the peak force required to break the contact is recorded as the test measurement of tackiness.

The compositions were then imagewise exposed using a phototool to create an array of tacky areas, the Mylar® cover sheet was removed, and the array was populated with 0.0762 mm to 1.27 mm (0.003 to 0.050 inch) diameter solder balls (63%Sn/37%Pb) and the excess solder balls were removed by a slight agitation and/or using a air/N₂ knife. The dimension of the tacky areas is approximately 20-30% of the diameter of the solder balls.

The above steps were all conducted under yellow safelight conditions.

A substrate containing metallized pads corresponding to the location and size of the solder balls on the populated array was then prepared and FORMON® 9553 solder flux was applied to the substrate. The populated array was then inverted and placed in contact with the substrate, such that the solder balls were in intimate registered contact with the fluxed metallized pads. The entire assembly was then subjected to either thermal release or photorelease. For the thermal release, the assembly was placed in either a Riston® PC 130 UV exposure system or a forced convection (air/N₂) reflow system, such as the Vitronics Universal SMR-800 and subjected to reflow under the following conditions: Ramp rate = 1.0 to 1.1 °C/second from 25°C to 225°C to 180°C. Dwell time = 25 to 30 seconds at 225°C. Nitrogen gas is used for reflow. The total time for this step is 265 seconds. Photorelease was accomplished by exposing the assebly to 500 mj of UV light through the Kapton® HD or ED 200D Mylar® base.

Following the release step, the photosensitive composition was peeled away from the substrate, which now contained the solder balls as solder bumps on the metallized pads, and the percent release of the solder balls was calculated. Results are shown below.

| Compositions A-D | | | | |
|---|---|---|---|---|
| Ingredient | Amount (Grams) | | | |
| | A | B | C | D |
| Acetone | 79.60 | 79.60 | 106.3 | 106.3 |
| Poly(methyl methacrylate), MW∼250,000 | 6.97 | 6.97 | 15.36 | 13.36 |
| Poly(methyl methacrylate), MW∼ 20-40,000 | 9.39 | 9.39 | | |
| Pentaerythritol triacrylate | 14.54 | 14.54 | 14.56 | 14.56 |
| Tetraethylene glycol dimethacrylate | 9.02 | 11.02 | 10.02 | 12.52 |
| Monoacrylate of resin from bisphenol A and epichlorohydrin, MW=3,500 | 12.53 | 12.53 | | |
| 2,2'-Bis(o-chloro- phenyl)-4,4',5,5'-tetraphenyl- biimidazole | 4.18 | 2.18 | 4.18 | 3.68 |
| 4,4'-Bis(diethylamino)benzophenone | .2510 | .2510 | .2510 | .2510 |
| Leuco Crystal Violet | .2750 | .2750 | .2750 | .2750 |
| 1,4,4-Trimethyl- 2,3-diazobicyclo-(3.2.3)-non-2-ene- dioxide | .0286 | .0286 | .0286 | .0286 |
| 4-Methoxyphenol | .0286 | .0286 | .0286 | .0286 |
| Diacrylate of resin from bisphenol A and epichlorohydrin [Viscosity @25°C = 10⁶ cps | | | 12.53 | 12.53 |

| Compositions E - G | | | |
|---|---|---|---|
| Ingredient | Amount (Grams) | | |
| | E | F | G |
| 1,4,4-Trimethyl- 2,3-diazobicyclo-(3.2.3)-non-2-ene- dioxide | .0167 | .0167 | .0167 |
| 4-Methoxyphenol | .0089 | .0089 | .0089 |
| Diacrylate of resin from bisphenol A and epichlorohydrin [Viscosity @25°C = 10⁶ cps | 6.20 | 6.20 | 6.20 |
| Methanol | 38.90 | 38.90 | 38.90 |
| Toluene | 38.90 | 38.90 | 38.90 |
| Ethyl acrylate (25.8%)/ methyl methacrylate (61.2%)/ acrylic acid (12.5%) Copolymer, MW=101-190,000, Acid No.=100, Tg=80°C | 9.08 | 9.08 | 9.08 |
| Ethyl acrylate (56%)/ methyl methacrylate (37%)/ acrylic acid (7%) Copolymer, MW=156-199,000, Acid No.=57, Tg=33°C | 6.02 | 6.02 | 6.02 |
| Trimethylolpropane trimethacrylate | 4.55 | 4.55 | 4.55 |
| 7-(4'-Chloro-6'-diethylamino-1',3',5'-triazine-4'-yl)amino-3-phenylcoumarin | .6850 | .6850 | .6850 |
| 2-Mercapto-benzoxazole | .2750 | .2750 | .2750 |
| Diethylhydroxylamine | .0367 | | |
| Tetraethyleneglycol dimethacrylate | 5.11 | 4.55 | 4.86 |
| 2,2'-Bis(o-chloro- phenyl)-4,4',5,5'-tetraphenyl- biimidazole | .57 | 1.17 | .87 |

| Compositions H - K | | | | |
|---|---|---|---|---|
| Ingredient | Amount (Grams) | | | |
| | H | I | J | K |
| Acetone | 80.0 | 80.0 | 80.0 | 80.0 |
| Poly(methyl methacrylate). MW∼250,000 | 2.44 | 2.44 | 2.44 | 2.44 |
| Poly(methyl methacrylate), MW = ∼ 20-40,000 | 2.73 | 2.73 | 2.73 | 2.73 |
| Pentaerythritol triacrylate | 4.20 | 4.20 | 4.20 | 4.20 |
| Monoacrylate of resin from bisphenol A and epichlorohydrin, MW = ∼3,500 | 4.20 | 4.20 | 4.20 | 4.20 |
| 2,2'-Bis(o-chloro- phenyl)-4,4',5,5'-tetraphenyl- biimidazole | 1.60 | 1.60 | 1.60 | 1.60 |
| 4,4'-Bis(diethylamino)benzophenone | .3600 | .3600 | .360 | .3600 |
| Leuco Crystal Violet | .2400 | .2400 | .240 | .2400 |
| 1,4,4-Trimethyl- 2,3-diazobicyclo-(3.2.3)-non-2-ene- dioxide | .0100 | .0100 | .010 | .0100 |
| 4-Methoxyphenol | .0100 | .0100 | .010 | .0100 |
| 1,6-Hexanediol dimethacrylate | 4.20 | | | |
| Dimethacrylate of Polyethyleneglycol of MW 600 | | 4.20 | | |
| Diethyleneglycol dimethacrylate | | | 4.20 | |
| Sartomer® SR495⁽¹⁾ | | | | 4.20 |

| | | | | |
|---|---|---|---|---|
| (1) Proprietary polyester acrylate of the Sartomer Company, Exton, PA | | | | |

| Results | | | |
|---|---|---|---|
| Composition | Tackiness (g/mm²) | Release Method | % Balls Released |
| A | 7.8 | Thermal | ∼100 |
| B | 6.7 | Thermal | ∼100 |
| C | 1.6 | Thermal | ∼100 |
| D | 2.2 | Thermal | ∼100 |
| E | 4.9 | UV | 3.7 |
| F | 2.3 | UV | 6.6 |
| G | 2.2 | UV | 5.2 |
| H | 1.0 | UV | 85 |
| I | 1.0 | UV | 5 |
| J | 0.3 | UV | -- |
| K | 0.6 | UV | 17 |

## Claims

1. An article for use in mounting an array of particles to contact pads of an electronic device, the artice comprising a surface having thereon an array of tacky and non-tacky areas, wherein each of the tacky areas has a size and bonding strength suitable for adhesion of one particle thereto, wherein the tacky areas are not disposed above the plane of the non-tacky areas and wherein an electrically conductive particle is attached to each tacky area.

2. The article of claim 1 wherein the electrically conductive particle is selected from the group consisting of solder and solder with flux.

3. The article of claim 1, wherein the surface comprises a photohardenable composition.

4. The article of claim 5, wherein the substrate is selected from polyimide film, glass, quartz, metal, and plastic.

5. The article of claim 1, wherein the tacky areas are disposed coplanar with the non-tacky areas.

6. A method for mounting an array of particles on contact pads of electronic devices, comprises the steps of:
(a) providing a surface having an array of tacky and non-tacky areas thereon, each tacky area having one electrically conductive particle adhered thereto;
(b) placing the electrically conductive particles in contact with an electronic device having contact pads such that the particles on the array are placed in registry with the contact pads;
(c) disassociating the electrically conductive particles from the tacky areas and adhering the particles to the respective contact pads.

7. The method of claim 8, wherein the step of disassociating the electrically conductive particles from the tacky areas is selected from mechanical disassociation, thermal disassociation and photodisassociation.

8. The method of claim 6 wherein the electrically conductive particle is selected from the group consisting of solder and solder with flux.
